# EUROPÄISCHE PATENTSCHRIFT

(11) **EP 3 342 147 B1**
(45) Veröffentlichungstag und Bekanntmachung des Hinweises auf die Patenterteilung: **22.04.2020**
(21) Anmeldenummer: 16750125.3
(22) Anmeldetag: 26.07.2016
(51) Int. Cl.: H04N 5/225, G01J 5/00, G01J 5/04, G01J 5/10, H01L 27/00, H01L 31/00, G01J 5/02, G01J 5/20, H01L 49/02, G01J 5/08

(54) **MIKROELEKTRONISCHE BAUELEMENTANORDNUNG, SYSTEM MIT EINER MIKROELEKTRONISCHEN BAUELEMENTANORDNUNG UND ENTSPRECHENDES HERSTELLUNGSVERFAHREN FÜR EINE MIKROELEKTRONISCHE BAUELEMENTANORDNUNG**
MICROELECTRONIC COMPONENT ASSEMBLY, SYSTEM HAVING A MICROELECTRONIC COMPONENT ASSEMBLY, AND CORRESPONDING PRODUCTION METHOD FOR A MICROELECTRONIC COMPONENT ASSEMBLY
AGENCEMENT DE COMPOSANTS MICROÉLECTRONIQUES, SYSTÈME COMPRENANT UN AGENCEMENT DE COMPOSANTS MICROÉLECTRONIQUES ET PROCÉDÉ DE FABRICATION CORRESPONDANT POUR UN AGENCEMENT DE COMPOSANTS MICROÉLECTRONIQUES

(30) Priorität: 28.08.2015 DE 102015216461
(43) Veröffentlichungstag der Anmeldung: 04.07.2018
(73) Patentinhaber: Robert Bosch GmbH, 70442 Stuttgart (DE)
(72) Erfinder: HERRMANN, Ingo, 71292 Friolzheim (DE); UTERMOEHLEN, Fabian, 71229 Leonberg (DE); HENRICI, Fabian, Palo Alto, California 943041223 (US)
(86) Internationale Anmeldenummer: PCT/EP2016/067723
(87) Internationale Veröffentlichungsnummer: WO 2017/036675

(56) Entgegenhaltungen:
- EP-A2- 2 226 648
- US-A1- 2003 007 084
- US-A1- 2008 180 566
- US-A1- 2013 153 766
- US-A1- 2013 235 210
- US-A1- 2014 151 834
- US-B1- 7 683 321

## Beschreibung

Die vorliegende Erfindung betrifft eine mikroelektronische Bauelementanordnung, ein System mit einer mikroelektronischen Bauelementanordnung und ein Herstellungsverfahren für eine mikroelektronische Bauelementanordnung.

### Stand der Technik

Thermische Ferninfrarot (FIR) oder Infrarot (IR) Imager, welche insbesondere einen Sensorchip zum Erfassen von Thermographiebildern umfassen, basieren auf einem modularen Aufbau, wobei die einzelnen Komponenten derartiger thermischen Imager in einem Gehäuse verbaut bzw. integriert sind. Derartige thermische Ferninfrarot Imager oder Infrarot Imager umschließen entweder direkt als Sleeve ein Smartphone oder andere mobile Vorrichtungen. Ferner kann der thermische Ferninfrarot Imager als ein Ansteckmodul mit einem Smartphone oder einem anderen mobilen Gerät verbunden sein.

Die US 2014/0253375 A1 beschreibt eine Vorrichtung mit einem Infrarot-Bildsensor.

Die US 2013/235210 A1 offenbart eine mikroelektronische Bauelementanordnung zum chipbasierten Erfassen von Thermographiebildern

Die US 2014/151834 A1 offenbart eine mikroelektronische Bauelementanordnung mit einem bolometrischen Detektor zum Erfassen von Infrarotstrahlung.

### Offenbarung der Erfindung

Die vorliegende Erfindung schafft eine mikroelektronische Bauelementanordnung nach Anspruch 1, ein System mit einer mikroelektronischen Bauelementanordnung nach Anspruch 5 und ein entsprechendes Herstellungsverfahren für eine mikroelektronische Bauelementanordnung nach Anspruch 7.

Bevorzugte Weiterbildungen sind Gegenstand der jeweiligen Unteransprüche.

### Vorteile der Erfindung

Die vorliegende Erfindung ermöglicht es, mikroelektronische Bauelementanordnungen, die zum Erfassen von Thermographiebildern eingesetzt werden können, auf Waferlevel besonders zeit- und kostensparend herzustellen. Derartige mikroelektronische Bauelementanordnungen können auch als thermal Chip-Scale-Imager bezeichnet werden.

Somit ermöglicht die mikroelektronische Bauelementanordnung eine geringe Baugröße und einfache Systemintegration. Insbesondere kann besonders zeitsparend eine flache mikroelektronische Bauelementanordnung auf Waferlevel hergestellt werden. Ferner kann die mikroelektronische Bauelementanordnung kosteneffizient hergestellt werden, da die einzelnen Komponenten der mikroelektronischen Bauelementanordnung nicht in einzelnen Herstellungsverfahren, sondern auf Waferlevel hergestellt werden können.

Im vorliegenden Zusammenhang versteht man unter "Waferlevel" ein Bereitstellen von funktionalen Komponenten, beispielsweise Sensorchip und Auswerteschaltung, als integrale Bestandteile eines Wafers. Dies hat den Vorteil, dass die einzelne mikroelektronische Bauelementanordnung besonders kleinbauend sein kann, da diese keine separat hergestellte Schaltungskomponenten neben dem Sensorchip benötigen. Der Sensorchip kann insbesondere ein Pixelarray zum Detektieren von FIR und/oder IR-Strahlung umfassen.

Zwischen der Linse und dem Sensorchip ist ein Vakuum ausgebildet. So lässt sich eine Streuung der infraroten und/oder ferninfraroten Strahlung reduzieren. Insbesondere kann durch eine höhere thermische Entkopplung von einem Imager Pixel eine höhere Sensitivität erreicht werden. Das Vakuum lässt sich beispielsweise durch Silizium-Direktbonden zwischen dem Sensorchip und der Linse konstant halten.

Zwischen der Linse und dem Sensorchip sind eine Kappe und eine Blende angeordnet, wobei sich die Blende zwischen der Linse und der Kappe befindet und entsprechende Seitenflächen der Kappe und Blende zumindest bereichsweise die Spuren des mechanischen Abtrags aufweisen. Das heißt, dass die Seitenflächen der Linse und der Blende bündig mit der Seitenfläche des Sensorchips abschließen können, wobei die Spuren des mechanischen Abtrags insbesondere auf einen Vereinzelungsprozess zurückführbar sein können. So lässt sich insbesondere eine erforderliche Brennweite zum Sensorchip einfach einstellen.

Gemäß einer weiteren bevorzugten Weiterbildung beträgt ein Abstand zwischen der Vorderseite des Sensorchips und einer Außenfläche der Linse zwischen 500 Mikrometer und 2,5 Millimeter. Aufgrund der integralen Bauweise basierend auf einem gemeinsamen Wafer, auf welchem der Sensorchip sowie die Auswerteschaltung und die Linse auf Waferlevel hergestellt werden können, kann eine geringe vertikale Ausdehnung der mikroelektronischen Bauelementanordnung erzielt werden.

Gemäß einer weiteren bevorzugten Weiterbildung umfasst der Sensorchip einen Metallspiegel. Somit kann die IR- oder FIR-Strahlung effizient reflektiert werden.

Gemäß einer weiteren bevorzugten Weiterbildung umfasst die Auswerteschaltung an einer dem Sensorchip abgewandten Seite ein BGA. So lässt sich die mikroelektronische Bauelementanordnung in ein System mit weiteren Komponenten, beispielsweise Mikrocontrollern, Speicherbausteinen oder Schaltungskomponenten (Spannungswandler) und/oder Leiterplatten, einfach elektrisch kontaktieren bzw. integrieren.

Gemäß einer weiteren bevorzugten Weiterbildung umfasst die mikroelektronische Bauelementanordnung eine oder mehrere Linsen aus Infrarot (IR) und/oder Ferninfrarot (FIR) transparentem Material, wobei die Linsen hinsichtlich einer Referenzebene konvex oder konkav geformt sein können. Die Linsen können beispielsweise Silizium (Si), Germanium (Ge) oder ein anderes geeignetes Halbleitermaterial umfassen. Ferner können die Linsen beispielsweise Kunststoff und/oder Glas umfassen. Ferner können die Linsen Beschichtungen aufweisen, um beispielsweise eine Reflexion an ihrer Oberfläche zu vermindern, wobei diese Beschichtungen ein- oder doppelseitig auf der Linse aufgebracht werden können.

Gemäß einer weiteren bevorzugten Weiterbildung umfasst die mikroelektronische Bauelementanordnung ein Pixelarray zum Erfassen der IR- und/oder FIR-Strahlung. Mit anderen Worten umfasst der Sensorchip an der Vorderseite ein Pixelarray. Hierbei kann es sich insbesondere um ein Mikrobolometer-Pixelarray handeln. Das Mikrobolometer-Pixelarray kann hierbei auf einem der folgenden thermoelektrischen Wandlerprinzipien basieren: resistiv, PN-Diode oder kapazitiv.

Gemäß einer weiteren bevorzugten Weiterbildung umfasst die Auswerteschaltung einen ASIC. Der ASIC kann insbesondere auf einem gemeinsamen Substrat lateral an dem Sensorchip angeschlossen sein oder kann den Sensorchip zumindest bereichsweise umschließen. Alternativ kann der ASIC auf einem gemeinsamen Wafer in vertikaler Richtung unterhalb des Sensorchips angeordnet sein. Der ASIC kann insbesondere auf einem weiteren Substrat angeordnet sein und über ein geeignetes Bondverfahren, beispielsweise SLID (=Solid Liquid Interdiffusion) Bonden, auf Chip- und/oder Waferlevel mit dem Sensorchip verbunden sein. Eine elektrische Kontaktierung der mikroelektronischen Bauelementanordnung mit beispielsweise weiteren Komponenten kann beispielsweise über das BGA an einer ASIC-Unterseite, optional über einen Interposer, realisierbar sein.

Gemäß einer weiteren bevorzugten Weiterbildung erfolgt eine Kommunikation der mikroelektronischen Bauelementanordnung über ein Interface. Für den Einsatz als Interface kommen beispielsweise Inter-Integrated Circuit oder Ethernet in Frage.

Gemäß einer weiteren bevorzugten Weiterbildung umfasst die mikroelektronische Bauelementanordnung Speicherbauteile, Spannungswandler oder weitere Komponenten. Das Speicherbauteil kann insbesondere eine Komponente eines Smartphones sein.

Die mikroelektronische Bauelementanordnung kann in einem System umfassend einen Interposer oder einer Leiterplatte angeordnet sein. Hierbei kann es sich bei der mikroelektronischen Bauelementanordnung um eine eigenständige in einem separaten Herstellungsverfahren auf Waferlevel hergestellte mikroelektronische Komponente handeln. Mit anderen Worten kann die mikroelektronische Bauelementanordnung als eine in sich funktionierende Komponente des Systems angesehen werden, wobei mittels des Interposers oder der Leiterplatte zumindest ein Mikrocontroller mit der mikroelektronischen Bauelementanordnung elektrisch kontaktierbar ist.

Gemäß einer bevorzugten Weiterbildung des Systems schirmt ein drehbarer Shutter die mikroelektronische Bauelementanordnung ab und der drehbare Shutter ist auf der Leiterplatte angeordnet. So lässt sich die mikroelektronische Bauelementanordnung während einer Nicht-Inbetriebnahme vor äußeren Beschädigungen schützen. Insbesondere kann die Linse durch den drehbaren Shutter geschützt werden. Der Shutter kann insbesondere elektrostatisch betrieben werden.

Die hier beschriebenen Merkmale der mikroelektronischen Bauelementanordnung gelten entsprechend für das System mit einer mikroelektronischen Bauelementanordnung und für das Herstellungsverfahren für eine mikroelektronische Bauelementanordnung sowie umgekehrt.

### Kurze Beschreibung der Zeichnungen

Weitere Merkmale und Vorteile der vorliegenden Erfindung werden nachfolgend anhand von Ausführungsformen mit Bezug auf die Figuren erläutert.

Es zeigen:
- Fig. 1: eine schematische senkrechte Querschnittsansicht zum Erläutern einer mikroelektronischen Bauelementanordnung und eines entsprechenden Herstellungsverfahrens gemäß einer ersten Ausführungsform der vorliegenden Erfindung;
- Fig. 2: eine schematische senkrechte Querschnittsansicht zum Erläutern einer mikroelektronischen Bauelementanordnung und eines entsprechenden Herstellungsverfahrens gemäß einer zweiten Ausführungsform der vorliegenden Erfindung;
- Fig. 3a-3c: weitere schematische senkrechte Querschnittsansichten zum Erläutern einer mikroelektronischen Bauelementanordnung und eines entsprechenden Herstellungsverfahrens gemäß weiterer Ausführungsformen der vorliegenden Erfindung;
- Fig. 4: eine schematische senkrechte Querschnittsansicht zum Erläutern eines Systems mit einer mikroelektronischen Bauelementanordnung gemäß einer ersten Ausführungsform der vorliegenden Erfindung;
- Fig. 5: eine weitere schematische senkrechte Querschnittsansicht zum Erläutern eines Systems mit einer mikroelektronischen Bauelementanordnung gemäß einer zweiten Ausführungsform der vorliegenden Erfindung;
- Fig. 6: eine weitere schematische senkrechte Querschnittsansicht zum Erläutern eines Systems mit einer mikroelektronischen Bauelementanordnung gemäß einer dritten Ausführungsform der vorliegenden Erfindung;
- Fig. 7: eine weitere schematische senkrechte Querschnittsansicht zum Erläutern eines Systems mit einer mikroelektronischen Bauelementanordnung gemäß einer vierten Ausführungsform der vorliegenden Erfindung;
- Fig. 8: eine weitere schematische senkrechte Querschnittsansicht zum Erläutern eines Systems mit einer mikroelektronischen Bauelementanordnung gemäß einer fünften Ausführungsform der vorliegenden Erfindung; und
- Fig. 9: ein Flussdiagramm zum Erläutern eines Ablaufs eines Herstellungsverfahrens für eine mikroelektronische Bauelementanordnung oder eines Systems gemäß der vorliegenden Erfindung.

### Ausführungsformen der Erfindung

In den Figuren bezeichnen gleiche Bezugszeichen gleiche bzw. funktionsgleiche Elemente.

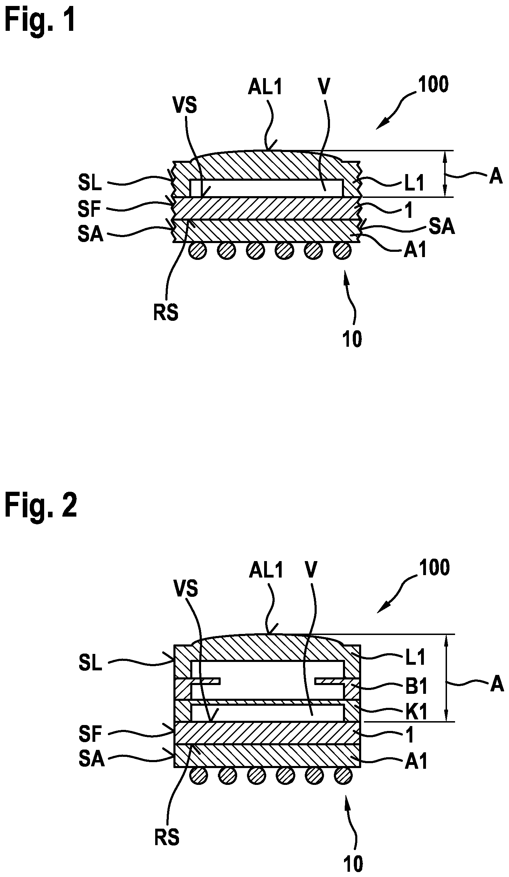

Fig. 1 ist eine schematische senkrechte Querschnittsansicht zum Erläutern einer mikroelektronischen Bauelementanordnung und eines entsprechenden Herstellungsverfahrens gemäß einer ersten Ausführungsform der vorliegenden Erfindung.

In Fig. 1 bezeichnet das Bezugszeichen 100 eine mikroelektronische Bauelementanordnung mit einem Sensorchip 1 zum Erfassen von Thermographiebildern. Der Sensorchip 1 umfasst eine Vorderseite VS, eine Rückseite RS und eine Seitenfläche SF, welche die Vorderseite VS mit der Rückseite RS des Sensorchips 1 verbindet.

In der Fig. 1 bezeichnet das Bezugszeichen A1 ferner eine Auswerteschaltung, wobei die Auswerteschaltung A1 an der Rückseite RS des Sensorchips 1 angeordnet ist. Eine Linse L1 ist auf der Vorderseite VS des Sensorchips 1 angeordnet und bedeckt diesen. Auf einer dem Sensorchip 1 abgewandten Seite der Auswerteschaltung A1 ist ein BGA 10 ausgebildet. In der Fig. 1 fungiert die Linse L1 als eine Vakuumverkappung. Die in der Fig. 1 gezeigte Seitenfläche SF des Sensorchips 1 und eine Seitenfläche SA der Auswerteschaltung A1 sowie eine Seitenfläche SL der Linse L1 weisen zumindest bereichsweise Spuren eines mechanischen Abtrags auf. Die Spuren des mechanischen Abtrags sind insbesondere auf einen Vereinzelungsprozess zurückzuführen, da die in der Fig. 1 gezeigte mikroelektronische Bauelementanordnung 100 auf einem Substrat integriert bzw. auf Waferlevel basierend hergestellt werden kann.

Das Bezugszeichen A bezeichnet einen Abstand zwischen der Vorderseite VS des Sensorchips 1 und einer Außenfläche AL1 der Linse L1. Der Abstand A kann zwischen 500 Mikrometer und 2,5 Millimeter betragen.

Fig. 2 ist eine schematische senkrechte Querschnittsansicht zum Erläutern einer mikroelektronischen Bauelementanordnung und eines entsprechenden Herstellungsverfahrens gemäß einer zweiten Ausführungsform der vorliegenden Erfindung.

In Fig. 2 bezeichnen die Bezugszeichen K1 eine Kappe und B1 eine Blende. Die Fig. 2 basiert auf der Fig. 1 mit dem Unterschied, dass zwischen der Linse L1 und dem Sensorchip 1 die Kappe K1 und die Blende B1 angeordnet sind, wobei sich die Blende B1 zwischen der Linse L1 und der Kappe K1 befindet und entsprechende Seitenflächen der Kappe K1 und der Blende B1 zumindest bereichsweise die Spuren des mechanischen Abtrags aufweisen. Des Weiteren beträgt der Abstand A zwischen der Vorderseite VS des Sensorchips 1 und der Außenfläche AL1 der Linse L1 zwischen 500 Mikrometer und 2,5 Millimeter.

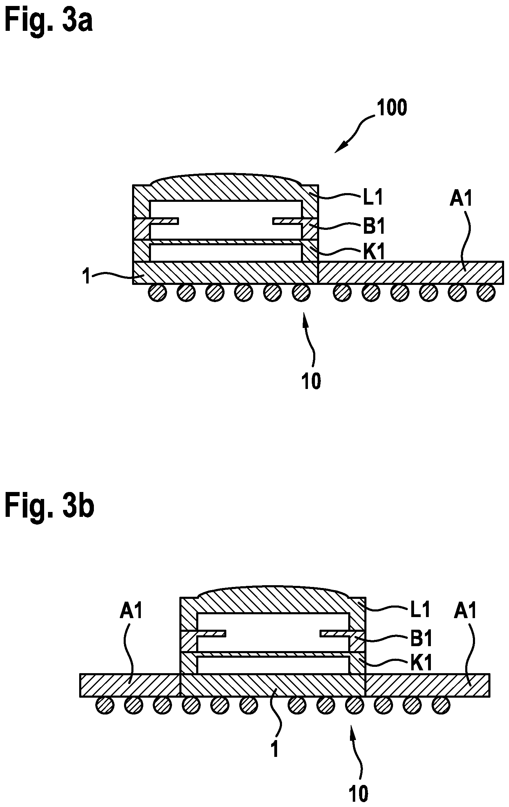

Fig. 3a - 3c sind weitere schematische senkrechte Querschnittsansichten zum Erläutern einer mikroelektronischen Bauelementanordnung und eines entsprechenden Herstellungsverfahrens gemäß weiterer Ausführungsformen der vorliegenden Erfindung.

Fig. 3a basiert auf der Fig. 2 mit dem Unterschied, dass die Auswerteschaltung A1 nicht an der Rückseite RS des Sensorchips 1, sondern an der Seitenfläche SF des Sensorchips angeordnet ist. Des Weiteren ist das BGA auf einer der Linse abgewandten Seite des Sensorchips 1 und der Auswerteschaltung A1 angeordnet.

Die Fig. 3b basiert auf der Fig. 3a mit dem Unterschied, dass die Auswerteschaltung A1 beidseitig an den Seitenflächen SF des Sensorchips 1 angeordnet sind. Ferner kann der Sensorchip 1 auch lateral mit der Auswerteschaltung A1 zumindest bereichsweise umschlossen sein.

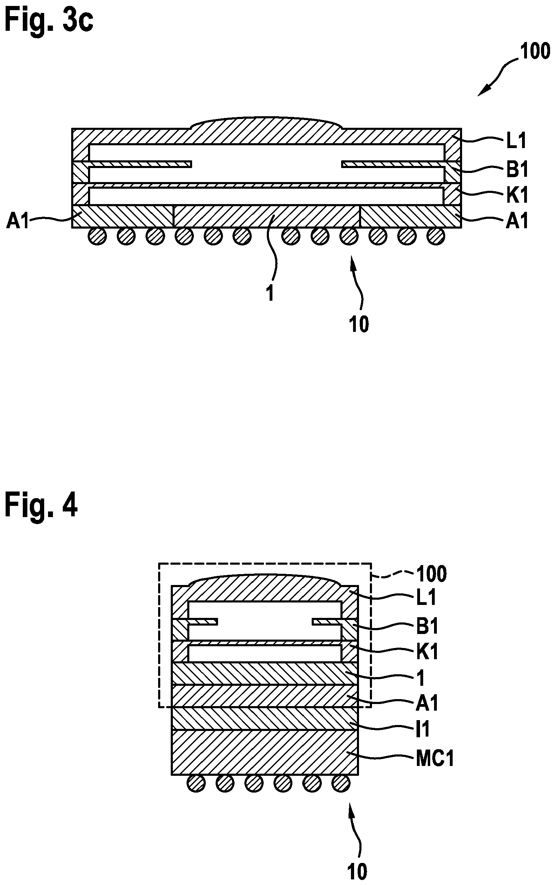

Die Fig. 3c basiert auf der Fig. 3b mit dem Unterschied, dass die Kappe K1, die Blende B1 und die Linse L1 den Sensorchip 1 sowie die Auswerteschaltungen A1 aus der Fig. 3b bedecken.

Fig. 4 ist eine schematische senkrechte Querschnittsansicht zum Erläutern eines Systems mit einer mikroelektronischen Bauelementanordnung gemäß einer ersten Ausführungsform der vorliegenden Erfindung.

Die Fig. 4 basiert auf der in Fig. 2 gezeigten mikroelektronischen Bauelementanordnung 100 mit dem Unterschied, dass die mikroelektronische Bauelementanordnung 100 als eine eigenständige Komponente eines Systems 110 fungiert. Die mikroelektronische Bauelementanordnung 100 ist durch einen gestrichelten Rahmen gekennzeichnet. Die Fig. 4 basiert hierbei auf der Fig. 2 mit dem Unterschied, dass zwischen dem BGA 10 und der Auswerteschaltung A1 ein Interposer I1 und ein Mikrocontroller MC1 angeordnet sind. Hierbei ist das BGA 10 an einer Seite des Mikrocontrollers MC1 angeordnet, die dem Sensorchip 1 abgewandt ist. In der Fig. 4 sind somit der Sensorchip 1, die Auswerteschaltung A1, der Interposer I1, der Mikrocontroller MC1 und das BGA 10 der mikroelektronischen Bauelementanordnung vertikal integriert. Insbesondere können entsprechende Seitenflächen des Interposers I1 und des Mikrocontrollers MC1 zumindest bereichsweise die Spuren des mechanischen Abtrags aufweisen.

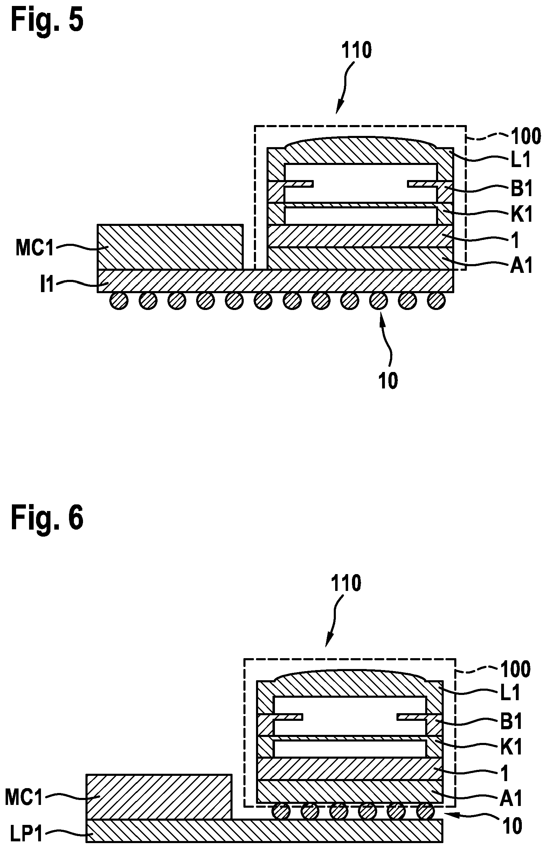

Fig. 5 ist eine weitere schematische senkrechte Querschnittsansicht zum Erläutern eines Systems mit einer mikroelektronischen Bauelementanordnung gemäß einer zweiten Ausführungsform der vorliegenden Erfindung.

Die zweite Ausführungsform des Systems 110 mit der mikroelektronischen Bauelementanordnung 100 basiert auf der Fig. 4 mit dem Unterschied, dass der Mikrocontroller MC1 mittels des Interposers I1 lateral zu der mikroelektronischen Bauelementanordnung 100 beabstandet ist. Mit anderen Worten fungiert der Interposer I1 der Fig. 5 als Träger für den Mikrocontroller MC1 und der mikroelektronischen Bauelementanordnung 100. Das BGA 10 ist hierbei auf einer dem Mikrocontroller MC1 und der mikroelektronischen Bauelementanordnung 100 abgewandten Seite des Interposers I1 durchgehend angeordnet.

Fig. 6 ist eine weitere schematische senkrechte Querschnittsansicht zum Erläutern eines Systems mit einer mikroelektronischen Bauelementanordnung gemäß einer dritten Ausführungsform der vorliegenden Erfindung.

Bei der dritten Ausführungsform weist das System 110 anstelle des Interposers I1 der Fig. 5 eine Leiterplatte LP1 auf, wobei zwischen der mikroelektronischen Bauelementanordnung 100 und der Leiterplatte LP1 das BGA 10 ausgebildet ist.

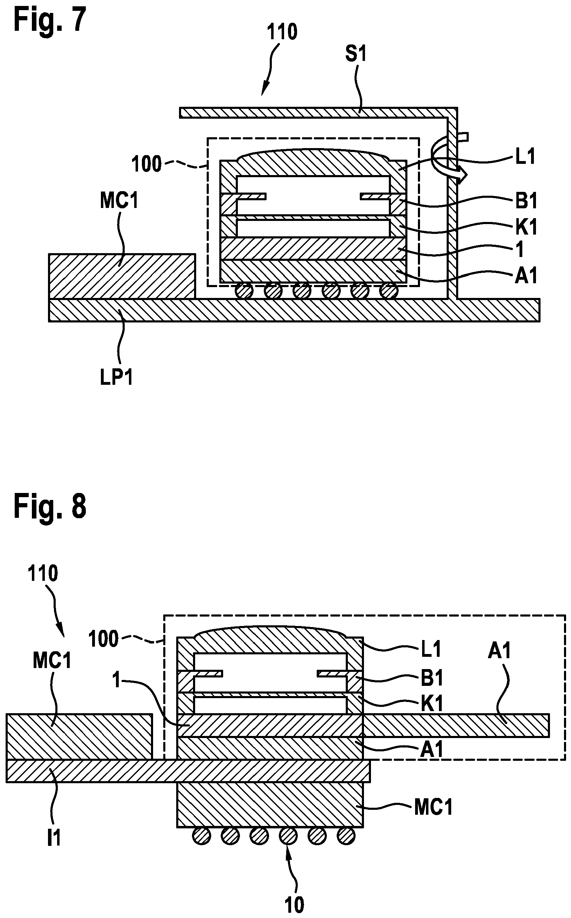

Fig. 7 ist eine weitere schematische senkrechte Querschnittsansicht zum Erläutern eines Systems mit einer mikroelektronischen Bauelementanordnung gemäß einer vierten Ausführungsform der vorliegenden Erfindung

Die vierte Ausführungsform des Systems 110 basiert auf der Fig. 6 mit dem Unterschied, dass auf der Leiterplatte LP1 einen drehbaren Shutter S1 aufweist. Der drehbare Shutter S1 kann insbesondere zum Abschirmen der mikroelektronischen Bauelementanordnung 100 vorgesehen sein. Der Shutter S1 kann insbesondere elektrostatisch betrieben werden.

Fig. 8 ist eine weitere schematische senkrechte Querschnittsansicht zum Erläutern eines Systems mit einer mikroelektronischen Bauelementanordnung gemäß einer fünften Ausführungsform der vorliegenden Erfindung.

Die fünfte Ausführungsform des Systems 110 basiert auf dem System 110 der Fig. 5 mit dem Unterschied, dass zusätzlich die Auswerteschaltung A1 an der Seitenfläche SF des Sensorchips 1 angeordnet ist und auf der der mikroelektronischen Bauelementanordnung 100 abgewandten Seite des Interposers I1 ein zusätzlicher Microcontroller MC1 angeordnet ist und der zusätzliche Microcontroller MC1 auf einer der mikroelektronischen Bauelementanordnung 100 abgewandten Seite des zusätzlichen Microcontrollers MC1 das BGA 10 angeordnet ist.

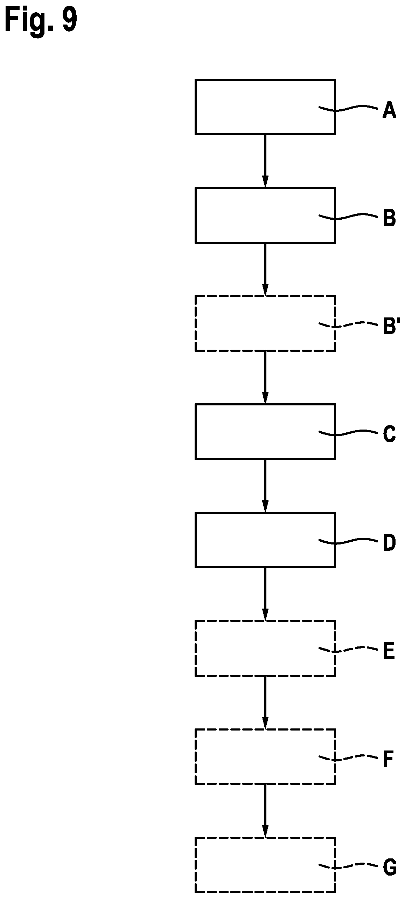

Fig. 9 zeigt ein Flussdiagramm zum Erläutern eines Ablaufes eines Herstellungsverfahrens für eine mikroelektronische Bauelementanordnung oder eines Systems mit einer mikroelektronischen Bauelementanordnung.

Die Verfahrensschritte der Fig. 9, die in gestrichelten Kästchen dargestellt sind, sind als optionale Verfahrensschritte zu verstehen.

Wie in der Fig. 9 gezeigt, umfasst das Herstellungsverfahren für die mikroelektronische Bauelementanordnung 100 die Schritte A, B, C und D. Bei den Verfahrensschritten B', E, F und G handelt es sich um optionale Verfahrensschritte des Herstellungsverfahrens für die mikroelektronische Bauelementanordnung 100 bzw. des Systems 110.

Im Schritt A wird zumindest ein Auswerteschaltungswafer A1' bereitgestellt. In dem Schritt B werden Sensoren 1' auf und/oder neben dem Auswerteschaltungswafer A1' bereitgestellt. Optional können in dem Schritt B' zwischen den Sensoren 1' und Linsen L1, Kappen K1 und Blenden B1 angeordnet werden, wobei sich die Blenden B1 zwischen den Linsen L1 und den Kappen K1 befinden. Erfolgt der optionale Schritt des Herstellungsverfahrens B' nicht, erfolgt im Schritt C ein Anordnen von Linsen jeweils auf einer Vorderseite VS' der Sensoren 1'. Anschließend wird im Schritt D die in den vorangegangenen Schritten hergestellte Anordnung in einzelne mikroelektronische Bauelementanordnungen 100 vereinzelt. Optional können anschließend in einem Verfahrensschritt E auf der dem Sensorchip 1 abgewandten Seite einer Auswerteschaltung A1 ein BGA 10 angeordnet werden.

Zur Herstellung eines Systems 110 mit der mikroelektronischen Bauelementanordnung 100, welches gemäß dem hier beschriebenen Herstellungsverfahren hergestellt wurde, wird die mikroelektronische Bauelementanordnung 100 mittels eines Interposers I1 oder einer Leiterplatte LP1 zumindest mit einem Mikrocontroller MC1 elektrisch kontaktiert. In dem optionalen Verfahrensschritt des Herstellungsverfahrens G wird ein drehbarer Shutter S1 auf der Leiterplatte LP1 angeordnet, wobei der drehbare Shutter S1 die mikroelektronische Bauelementanordnung 100 abschirmen kann.

Ferner laufen die Schritte A bis G in der wie in Fig. 9 gezeigten Reihenfolge ab.

Die hier beschriebene mikroelektronische Bauelementanordnung kann insbesondere in Smart-Phones, Mobile Devices und/oder Sensorknoten Einsatz finden. Hierbei kann der Einsatz der mikroelektronischen Bauelementanordnung autonom erfolgen, wobei die Energie zum Beispiel über eine Batterie, einem Akku und/oder Solarzellen, bereitgestellt werden kann. Eine Übertragung des Thermographiebildes an weitere Systeme kann hierbei entweder drahtlos, beispielsweise Bluetooth, WLAN oder über ein Bus-System erfolgen. Alternativ kann der Sensorknoten kabelgebunden oder festverdrahtet sein. Hierbei erfolgt die Stromversorgung über eine Festverdrahtung, beispielsweise einem Stromkabel.

## Patentansprüche

1. Mikroelektronische Bauelementanordnung (100) mit:
einem Sensorchip (1) zum Erfassen von Thermographiebildern mit einer Vorderseite (VS), einer Rückseite (RS) und eine Seitenfläche (SF), welche die Vorderseite (VS) mit der Rückseite (RS) verbindet;
zumindest einer Auswerteschaltung (A1), wobei die zumindest eine Auswerteschaltung (A1) mit dem Sensorchip (1) zumindest bereichsweise mit der Rückseite (RS) und/oder mit der Seitenfläche (SF) des Sensorchips (1) in Kontakt steht;
einer Linse (L1), wobei die Linse (L1) auf der Vorderseite (VS) des Sensorchips (1) angeordnet ist, wobei zwischen der Linse (L1) und dem Sensorchip (1) ein Vakuum (V) ausgebildet ist und zwischen der Linse (L1) und dem Sensorchip (1) eine Kappe (K1) angeordnet ist;
wobei die Seitenfläche (SF) des Sensorchips (1) und/oder eine Seitenfläche (SA) der Auswerteschaltung (A1) sowie eine Seitenfläche (SL) der Linse (L1) zumindest bereichsweise Spuren eines mechanischen Abtrags aufweisen;
**dadurch gekennzeichnet, dass**
die Linse (L1) den Sensorchip (1) bedeckt,
zwischen der Linse (L1) und dem Sensorchip (1) eine Blende (B1) angeordnet ist, wobei sich die Blende (B1) zwischen der Linse (L1) und der Kappe (K1) befindet und
entsprechende Seitenflächen der Kappe (K1) und der Blende (B1) zumindest bereichsweise die Spuren des mechanischen Abtrags aufweisen.

2. Mikroelektronische Bauelementanordnung (100) nach Anspruch 1, wobei ein Abstand (A) zwischen der Vorderseite (VS) des Sensorchips (1) und einer Außenfläche (AL1) der Linse (L1) zwischen 500 Mikrometer und 2,5 Millimeter beträgt.

3. Mikroelektronische Bauelementanordnung (100) nach einem der vorherigen Ansprüche, wobei der Sensorchip (1) einen Metallspiegel (M1) umfasst.

4. Mikroelektronische Bauelementanordnung (100) nach einem der vorherigen Ansprüche, wobei die Auswerteschaltung (A1) an einer dem Sensorchip (1) abgewandten Seite ein BGA (10) umfasst.

5. System (110) mit einer mikroelektronischen Bauelementanordnung (100) nach einem der Ansprüche 1 bis 4, wobei mittels eines Interposers (I1) oder einer Leiterplatte (LP1) zumindest ein Mikrocontroller (MC1) mit der mikroelektronischen Bauelementanordnung (100) elektrisch kontaktierbar ist.

6. System (110) nach Anspruch 5, wobei ein drehbarer Shutter (S1) die mikroelektronischen Bauelementanordnung (100) abschirmt und der drehbare Shutter (S1) auf der Leiterplatte (LP1) angeordnet ist.

7. Herstellungsverfahren für eine mikroelektronische Bauelementanordnung (100) mit den Schritten:
A) Bereitstellen zumindest eines Auswerteschaltungswafers (A1');
B) Bereitstellen von Sensorchips (1) auf und/oder neben dem Auswerteschaltungswafer (A1'), so dass zumindest eine Auswerteschaltung (A1) des Auswerteschaltungswafers (A1') mit einem jeweiligen Sensorchip (1) zur Erfassung von Thermographiebildern zumindest bereichsweise mit der Rückseite (RS) und/oder mit der Seitenfläche (SF) des Sensorchips (1) in Kontakt steht;
C) Anordnen von Linsen (L1) jeweils auf einer Vorderseite (VS) der Sensorchips (1), so dass eine Linse (L1) auf der Vorderseite (VS) des jeweiligen Sensorchips (1) angeordnet ist und zwischen der Linse (L1) und dem Sensorchip (1) ein Vakuum (V) ausgebildet ist;
D) Vereinzeln der in der in den Schritten A bis C hergestellten Anordnung in einzelne mikroelektronische Bauelementanordnungen (100),
**dadurch gekennzeichnet, dass** die Linse (L1) den jeweiligen Sensorchip (1) bedeckt und dass zwischen den jeweiligen Sensorchips (1) und den Linsen (L1), Kappen (K1) und Blenden (B1) angeordnet werden, wobei sich die Blenden (B1) zwischen den Linsen (L1) und den Kappen (K1) befinden und das Vereinzeln entsprechend durch die Kappen (K1) und Blenden (B1) durchgeführt wird.

8. Herstellungsverfahren nach Anspruch 7, wobei an einer dem Sensorchip (1) abgewandten Seite einer Auswerteschaltung (A1) eine BGA (10) angeordnet wird.

## Claims

1. Microelectronic component assembly (100) having:
a sensorchip (1) for capturing thermographic images with a front side (VS), a rear side (RS) and a side face (SF) which connects the front side (VS) to the rear side (RS);
at least one evaluation circuit (A1), wherein the at least one evaluation circuit (A1) is in contact with the sensorchip (1), at least in certain areas with the rear side (RS) and/or the side face (SF) of the sensorchip (1);
a lens (L1), wherein the lens (L1) is arranged on the front side (VS) of the sensorchip (1), wherein a vacuum (V) is formed between the lens (L1) and the sensorchip (1), and a cap (K1) is arranged between the lens (L1) and the sensorchip (1);
wherein the side face (SF) of the sensorchip (1) and/or a side face (SA) of the evaluation circuit (A1) as well as side face (SL) of the lens (L1) have traces of mechanical erosion at least in certain areas;
**characterized in that**
the lens (L1) covers the sensorchip (1),
a bezel (B1) is arranged between the lens (L1) and the sensorchip (1), wherein the bezel (B1) is located between the lens (L1) and the cap (K1), and
corresponding side faces of the cap (K1) and of the bezel (B1) have traces of mechanical erosion at least in certain areas.

2. Microelectronic component assembly (100) according to Claim 1, wherein a distance (A) between the front side (VS) of the sensorchip (1) and an outer face (AL1) of the lens (L1) is between 500 micrometres and 2.5 millimetres.

3. Microelectronic component assembly (100) according to one of the preceding claims, wherein the sensorchip (1) comprises a metal mirror (M1).

4. Microelectronic component assembly (100) according to one of the preceding claims, wherein the evaluation circuit (A1) comprises a BGA (10) on a side facing away from the sensorchip (1).

5. System (110) having a microelectronic component assembly (100) according to one of Claims 1 to 4, wherein at least one microcontroller (MC1) can be placed in electrical contact with the microelectronic component assembly (100) by means of an interposer (I1) or a circuit board (LP1).

6. System (110) according to Claim 5, wherein a rotatable shutter (S1) screens the microelectronic component assembly (100), and the rotatable shutter (S1) is arranged on the circuit board (LP1) .

7. Manufacturing method for a microelectronic component assembly (100) having the steps:
A) making available at least one evaluation circuit wafer (A1');
B) making available sensorchips (1) on and/or next to the evaluation circuit wafer (A1') so that at least one evaluation circuit (A1) of the evaluation circuit wafer (A1') is in contact with a respective sensorchip (1) for capturing thermographic images at least in certain areas with the rear side (RS) and/or with the side face (SF) of the sensorchip (1);
C) arranging lenses (L1) in each case on a front side (VS) of the sensorchips (1) so that one lens (L1) is arranged on the front side (VS) of the respective sensorchip (1), and a vacuum (V) is formed between the lens (L1) and the sensorchip (1) ;
D) separating the arrangement manufactured in steps A to C into individual microelectronic component assemblies (100),
**characterized in that** the lens (L1) covers the respective sensorchip (1), and **in that** caps (K1) and bezels (B1) are arranged between the respective sensorchips (1) and the lenses (L1), wherein the bezels (B1) are located between the lenses (L1) and the caps (K1), and
the separation is carried out correspondingly through the caps (K1) and bezels (B1).

8. Manufacturing method according to Claim 7, wherein a BGA (10) is arranged on a side of the evaluation circuit (A1) facing away from the sensorchip (1).

## Revendications

1. Agencement de composants microélectroniques (100) comprenant :
une puce de capteur (1) permettant de détecter des images thermographiques, présentant une face avant (VS), une face arrière (RS) et une face latérale (SF) reliant la face avant (VS) à la face arrière (RS) ;
au moins un circuit d'évaluation (A1), dans lequel ledit au moins un circuit d'évaluation (A1) comportant la puce de capteur (1) est au moins par endroits en contact avec la face arrière (RS) et/ou avec la face latérale (SF) de la puce de capteur (1) ;
une lentille (L1), dans lequel la lentille (L1) est disposée sur la face avant (VS) de la puce de capteur (1), dans lequel un vide (V) est ménagé entre la lentille (L1) et la puce de capteur (1) et un couvercle (K1) est disposé entre la lentille (L1) et la puce de capteur (1) ;
dans lequel la face latérale (SF) de la puce de capteur (1) et/ou une face latérale (SA) du circuit d'évaluation (A1) ainsi qu'une face latérale (S1) de la lentille (L1) présentent au moins par endroits des traces d'érosion mécanique ;
**caractérisé en ce que**
la lentille (L1) recouvre la puce de capteur (1),
un diaphragme (B1) est disposé entre la lentille (L1) et la puce de capteur (1), dans lequel le diaphragme (B1) est situé entre la lentille (L1) et le couvercle (K1) et des faces latérales correspondantes du couvercle (K1) et des diaphragmes (B1) présentent au moins par endroits les traces d'érosion mécanique.

2. Agencement de composants microélectroniques (100) selon la revendication 1, dans lequel une distance (A) entre la face avant (VS) de la puce de capteur (1) et une face extérieure (AL1) de la lentille (L1) est comprise entre 500 micromètres et 2,5 millimètres.

3. Agencement de composants microélectroniques (100) selon l'une des revendications précédentes, dans lequel la puce de capteur (1) comprend un miroir métallique (M1).

4. Agencement de composants microélectroniques (100) selon l'une des revendications précédentes, dans lequel le circuit d'évaluation (A1) comprend un BGA (10) sur une face qui est tournée à l'opposé de la puce de capteur (1).

5. Système (110) comportant un agencement de composants microélectroniques (100) selon l'une des revendications 1 à 4, dans lequel au moins un microcontrôleur (MC1) peut être mis en contact électrique avec l'agencement de composants microélectroniques (100) au moyen d'un dispositif d'interposition (I1) ou d'une carte de circuit imprimé (LP1).

6. Système (110) selon la revendication 5, dans lequel un obturateur tournant (S1) protège l'agencement de composants microélectroniques (100) et l'obturateur tournant (S1) est disposé sur la carte de circuit imprimé (LP1).

7. Procédé de fabrication d'un agencement de composants microélectroniques (100), comprenant les étapes qui consistent à :
A) fournir au moins une plaquette de circuits d'évaluation (A1') ;
B) fournir des puces de capteur (1) sur et/ou à proximité de la plaquette de circuits d'évaluation (A1') de manière à ce qu'au moins un circuit d'évaluation (A1) de la plaquette de circuits d'évaluation (A1') comportant une puce de capteur (1) respective et destiné à détecter une image thermographique soit au moins par endroits en contact avec la face arrière (RS) et/ou avec la face latérale (SF) de la puce de capteur (1) ;
C) agencer des lentilles (L1) sur une face avant (VS) des puces de capteur (1) de manière à ce qu'une lentille (L1) soit disposée sur la face avant (VS) de la puce de capteur (1) respective et qu'un vide (V) soit formé entre la lentille (L1) et la puce de capteur (1) ;
D) séparer l'agencement produit lors des étapes A à C en des agencements individuels de composants microélectroniques (100),
**caractérisé en ce que** la lentille (L1) recouvre la puce de capteur (1) respective et **en ce que** des couvercles (K1) et des diaphragmes (B1) sont disposés entre les puces de capteur (1) respectives et les lentilles (L1), dans lequel les diaphragmes (B1) sont situés entre les lentilles (L1) et les couvercles (K1), et
la séparation est effectuée de manière correspondante par l'intermédiaire des couvercles (K1) et des diaphragmes (B1) .

8. Procédé de fabrication selon la revendication 7, dans lequel un BGA (10) est disposé sur une face du circuit d'évaluation (A1) qui est tournée à l'opposé de la puce de capteur (1).
